# EUROPEAN PATENT APPLICATION

(11) **EP 4 818 710 A1**
(43) Date of publication of application: **07.10.2026**
(21) Application number: 26166330.6
(22) Date of filing: 20.03.2026
(51) Int. Cl.: G01R 31/12

(54) **SIGNAL INJECTION BASED ELECTRICAL ARC DETECTION**

(30) Priority: 04.04.2025 US 202519170624
(71) Applicant: Tesla, Inc., Austin, TX 78725 (US)
(72) Inventor: GONZALEZ, Pedro, Austin, TX, 78725 (US)
(74) Representative: Liesegang, Eva

(57) **Abstract**

An electrical system includes a power transmission component that has a first terminal and a second terminal, a signal generator, one or more electrical components connected to the first terminal and the second terminal, and a processing circuit. The signal generator injects an electrical signal to the one or more electrical components. The processing circuit measures first signal energy associated with the electrical signal at one or more particular frequencies at the first terminal, measures second signal energy associated with the electrical signal at the one or more particular frequencies at the second terminal, and determines an occurrence of an electrical arc associated with the one or more electrical components based at least in part on the first signal energy and the second signal energy.

## Description

### TECHNICAL FIELD

The present disclosure relates to electrical systems. More particularly, embodiments of the present disclosure relate to systems and methods for detecting electrical arcs.

### BACKGROUND

Electrical circuits, such as direct current (DC) electrical circuits, can be integrated in electrical systems to support various applications (e.g., solar, battery, power transmission, etc.). Electrical arcs (e.g., unintended electrical discharge) can cause thermal / safety issues and/or system failures, posing technical challenges to operation of electrical circuits. Improved arc detection is desired in certain applications.

### SUMMARY OF CERTAIN INVENTIVE ASPECTS

The systems, methods and devices of this disclosure each have several innovative embodiments, no single one of which is solely responsible for all of the desirable attributes disclosed herein. Details of one or more implementations of the subject matter described in this specification are set forth in the accompanying drawings and the description below.

In some aspects, the techniques described herein relate to an electrical system with electrical arc detection, the electrical system including: a power transmission component having a first terminal and a second terminal, the power transmission component including a signal generator configured to inject an electrical signal to one or more electrical components that are coupled between the first terminal and the second terminal; the one or more electrical components; a first circuit electrically connected to the first terminal, the first circuit configured to measure first signal energy associated with the electrical signal at one or more particular frequencies at the first terminal; a second circuit electrically connected to the second terminal, the second circuit configured to measure second signal energy associated with the electrical signal at the one or more particular frequencies at the second terminal; and a detection circuit in communication with the first circuit and the second circuit, the detection circuit configured to detect an occurrence of an electrical arc associated with the one or more electrical components based at least in part on the first signal energy and the second signal energy.

In some aspects, the techniques described herein relate to an electrical system, wherein the detection circuit determines the occurrence of the electrical arc associated with the one or more electrical components based at least in part on a difference between the first signal energy and the second signal energy.

In some aspects, the techniques described herein relate to an electrical system, wherein the first circuit measures the first signal energy and compares the measured first signal energy with a measurement from the second circuit after the occurrence of the electrical arc.

In some aspects, the techniques described herein relate to an electrical system, wherein the detection circuit determines the occurrence of the electrical arc associated with the one or more electrical components based on the first signal energy, the second signal energy, third signal energy, and fourth signal energy, and wherein: the first circuit is configured to measure the third signal energy associated with the electrical signal at the one or more particular frequencies at the first terminal prior to the occurrence of the electrical arc; and the second circuit is configured to measure the fourth signal energy associated with the electrical signal at the one or more particular frequencies at the second terminal prior to the occurrence of the electrical arc.

In some aspects, the techniques described herein relate to an electrical system, wherein the one or more particular frequencies are in a range from 10 kilohertz (kHz) to 150 kHz.

In some aspects, the techniques described herein relate to an electrical system, wherein the first circuit includes a Fourier Transform (FT) circuit.

In some aspects, the techniques described herein relate to an electrical system, wherein the one or more electrical components include at least one of: a solar cell or a battery cell.

In some aspects, the techniques described herein relate to an electrical system, wherein the one or more electrical components include a plurality of electrical components in series with each other between the first terminal and the second terminal.

In some aspects, the techniques described herein relate to an electrical system, wherein the signal generator includes a solenoid.

In some aspects, the techniques described herein relate to an electrical system, further including additional electrical components coupled between the first terminal and the second terminal, the additional electrical components in series with each other and in parallel with the one or more electrical components, wherein the signal generator is configured to inject a second electrical signal to the additional electrical components, and wherein the detection circuit is configure to detect an occurrence of a second electrical arc associated with the additional electrical components based at least in part on the first signal energy and the second signal energy.

In some aspects, the techniques described herein relate to a method of detecting an electrical arc associated with one or more electrical components, the method including: injecting an electrical signal into an electrical loop, the electrical loop including a first terminal of a power transmission component, a second terminal of the power transmission component, and the one or more electrical components electrically coupled between the first terminal and the second terminal; generating a first indication of first signal energy associated with the electrical signal at one or more particular frequencies at the first terminal; generating a second indication of second signal energy associated with the electrical signal at the one or more particular frequencies at the second terminal; and detecting the electrical arc associated with the one or more electrical components based at least in part on the first indication and the second indication.

In some aspects, the techniques described herein relate to a method, further including: injecting one or more calibration signals into the electrical loop; receiving one or more electrical responses associated with the one or more calibration signals from the electrical loop; and determining, based on the one or more electrical responses, that electrical arcs associated with the one or more electrical components cause significant energy absorption in the electrical loop at the one or more particular frequencies.

In some aspects, the techniques described herein relate to a method, wherein the first indication and the second indication are generated after an occurrence of the electrical arc.

In some aspects, the techniques described herein relate to a method, further including: generating a third indication of third signal energy associated with the electrical signal at the one or more particular frequencies at the first terminal prior to the occurrence of the electrical arc; generating a fourth indication of fourth signal energy associated with the electrical signal at the one or more particular frequencies at the second terminal prior to the occurrence of the electrical arc; and detecting the electrical arc associated with the one or more electrical components based on the first indication, the second indication, the third indication, and the fourth indication.

In some aspects, the techniques described herein relate to a method, wherein the one or more particular frequencies are in a range from 10 kilohertz (kHz) to 150 kHz.

In some aspects, the techniques described herein relate to a method, wherein generating the first indication uses a first Fourier Transform (FT) circuit and generating the second indication uses a second Fourier Transform (FT) circuit.

In some aspects, the techniques described herein relate to a method, wherein the one or more electrical components include at least one of: a solar cell, or a battery cell. 20.

In some aspects, the techniques described herein relate to a method, wherein the one or more electrical components include a plurality of electrical components in series with each other between the first terminal and the second terminal.

In some aspects, the techniques described herein relate to a method, wherein the power transmission component includes an inverter or a transformer.

In some aspects, the techniques described herein relate to a method, wherein the electrical signal is injected into the electrical loop by a solenoid.

### BRIEF DESCRIPTION OF THE DRAWINGS

Throughout the drawings, reference numbers are re-used to indicate correspondence between referenced elements. The drawings are provided to illustrate examples of the subject matter described herein and not to limit the scope thereof.

Embodiments of the present disclosure are described with reference to the accompanying drawings, in which like reference characters reference like elements, and wherein:
FIG. 1 is an example schematic block diagram of an electrical system that can detect electrical arcs in accordance with some embodiments of the present disclosure.
FIG. 2 is an example timeline of detecting electrical arcs using the electrical system of FIG. 1 in accordance with some embodiments of the present disclosure.
FIG. 3 is an example schematic block diagram of an electrical system that can detect electrical arcs in accordance with some embodiments of the present disclosure.
FIG. 4 is an example schematic block diagram of an electrical system that can detect electrical arcs in accordance with some embodiments of the present disclosure.

### DETAILED DESCRIPTION OF CERTAIN EMBODIMENTS

The following description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings. Any suitable principles and advantages of the embodiments disclosed herein can be implemented together with each other.

Generally described, one or more aspects of the present disclosure relate to methods and systems for detecting electrical arcs by injecting one or more signals at a one or more particular frequencies (e.g., one or more frequencies at which an electrical arc absorbs or consumes most energy) into an electrical system and measuring, at distinct locations (e.g., different points or nodes in an electrical loop or an electrical circuit of the electrical system), signal energy at the one or more particular frequencies. More specifically, some embodiments of the present disclosure disclose injecting a controlled signal (e.g., using a signal generator to inject an electrical signal of one or more particular frequencies) into an electrical loop that includes one or more electrical components (e.g., battery cells, solar cells, and/or the like) coupled between terminals of a power transmission component, measuring signal energy at the one or more particular frequencies at multiple nodes in the electrical loop, and performing frequency domain analysis to determine an occurrence of an electrical arc associated with the one or more electrical components (e.g., within the one or more electrical components). The electrical components can be direct current (DC), alternating current (AC), or combinations thereof.

Advantageously, by injecting an electrical signal at one or more particular frequencies for detecting electrical arcs, a signal-to-noise ratio (SNR) associated with electrical arc detection can be enhanced or improved compared with existing methods that involve using uncontrolled signals to detect electrical arcs. The improved SNR can reduce the likelihood of false positives and/or nuisance tripping, leading to more reliable and accurate electrical arc detection. Additionally, by measuring signal energy at multiple nodes (e.g., a positive terminal of an inverter and a negative terminal of the inverter) in an electrical loop and comparing signal energy at the multiple nodes before and/or after an occurrence of an electrical arc, the electrical arc can be detected at any time after an occurrence of the electrical arc. In contrast, certain existing methods that measure signal energy at a single node of an electrical circuit may only detect an electrical arc within a relatively narrow time window (e.g., shortly after an occurrence of the electrical arc).

Further, systems of the present disclosure can reuse at least some hardware used in existing systems and support electrical arc detection mechanisms (e.g., measuring signal energy at a single node) performed by existing systems. As such, the disclosed system can be compatible and/or be integrated into existing infrastructure without significant system redesign. The disclosed systems can also support electrical arc detection in parallel electrical loops or electrical circuits. For example, by controlling amplitudes and/or frequencies of injected signals, the disclosed system can be adaptable to detecting electrical arc under various circuit topologies, complexities, and/or structures.

In the field of power transmission systems and/or electromagnetic systems, electrical arcs (e.g., unintended electrical discharge, electricity crossing an air gap or other uncontrolled path to a ground) can pose significant design challenges due to their potential to cause thermal events and system failures. Once an electric arc occurs, the electrical arc can persist, leading to continuous discharge and increased risk associated with operations of electrical circuits. Detecting electrical arcs is therefore significant for maintaining safety and reliability of electrical systems.

Existing electrical arc detection methods can involve comparing energy released by electrical arcs at frequencies (e.g., between or in a range from 10 kHz to 150 kHz) both before and after an occurrence of an electrical arc. For example, some methods for detecting electrical arcs may involve monitoring changes in frequency components of electrical signals on a signal bus, and continually comparing energy levels at certain frequencies measured at different timestamps. These methods may determine an occurrence of the electrical arc if a difference between energy levels measured at two timestamps exceeds a threshold. For example, an energy level at a particular frequency measured before the occurrence of the electrical arc may be higher than another energy level at the particular frequency measured after the occurrence of the electrical arc because of energy absorption characteristics associated with the electrical arc.

However, because energy released and/or absorbed by electrical arcs may be relatively low, existing detection methods can encounter technical challenges associated with relatively low SNR, such as numerous false positives and nuisance tripping. Additionally, existing methods can involve measuring or calculating (e.g., using Fast Fourier Transform (FFT)) signal energy continually at various frequencies at a single location (e.g., a single node in an electrical loop or circuit), and compare FFT outputs before and after an occurrence of an electrical arc to determine the occurrence. However, these methods that involve detection at a single location may only detect the electrical arc within a relatively narrow time window (e.g., immediately after an occurrence of an electrical arc), which can substantially limit their detection capabilities.

To address at least a portion of the above problems, some embodiments of the present disclosure disclose systems and methods for detecting electrical arcs by injecting a controlled signal (e.g., an electrical signal of one or more particular frequencies) into an electrical loop that includes one or more electrical components (e.g., direct current (DC) components such as battery cells, solar cells, and/or the like), measuring signal energy at the one or more particular frequencies at multiple nodes in the electrical loop, and/or performing frequency domain analysis to determine an occurrence of an electrical arc associated with the one or more electrical components.

In some examples, a system for detecting electrical arcs can include a power transmission component (e.g., an inverter, a transformer, or the like), one or more electrical components (e.g., DC components such as battery cells, solar cells, and/or the like), a first circuit, a second circuit, and a processing circuit. The power transmission component can have a first terminal (e.g., a positive terminal) and a second terminal (e.g., a negative terminal). The one or more electrical components can be electrically connected between the first terminal and the second terminal. The power transmission component can include a signal generator. The signal generator can inject, through the first terminal, an electrical signal into the electrical loop between the first terminal and the second terminal that includes the one or more electrical components.

The first circuit can be electrically connected to the first terminal. The first circuit can be configured to measure first signal energy associated with the electrical signal at one or more particular frequencies (e.g., 50 kHz and 80KHz) at the first terminal. For example, the first circuit can generate a first indication of first signal energy associated with the electrical signal at the one or more particular frequencies at the first terminal. The second circuit can be electrically connected to the second terminal. The second circuit can be configured to measure second signal energy associated with the electrical signal at the one or more particular frequencies at the second terminal. For example, the second circuit can generate a second indication of second signal energy associated with the electrical signal at the one or more particular frequencies at the first terminal. The processing circuit can be in communication with the first circuit and the second circuit. The processing circuit can be configured to determine an occurrence of an electrical arc associated with the one or more electrical components based at least in part on the first signal energy and the second signal energy. For example, the processing circuit can detect the electrical arc associated with the one or more electrical components based at least in part on the first indication and the second indication.

In some examples, the first circuit can measure the first signal energy and the second circuit can measure the second signal energy after the occurrence of the electrical arc. The processing circuit can determine an occurrence of the electrical arc associated with the one or more electrical components based at least in part on a difference between the first signal energy and the second signal energy. In other examples, the processing circuit can determine an occurrence of the electrical arc based on both signal energy calculated before and after the occurrence of the electrical arc. The processing circuit and/or other circuitry can cause a corrective action to take place in response to detecting the electrical arc.

In some examples, the one or more particular frequencies can be determined based on energy absorption characteristics of electrical arcs associated with the one or more electrical components. For example, the system can perform a calibration process (e.g., through frequency sweeping) to characterize or determine frequencies at which electrical arcs associated with the one or more electrical components occur and/or absorb significant energy (e.g., maximum energy or near maximum energy). More specifically, the system can inject calibration signals at various frequencies (e.g., from 10 kHz to 150 kHz) toward the one or more electrical components and analyze responses associated with the calibration signals to determine one or more frequencies at which electrical arcs associated with the one or more electrical components absorb the most energy. The system may then set the one or more frequencies (e.g., 100 kHz and 120 kHz) at which electrical arcs absorb the most energy as the one or more particular frequencies (e.g., 100 kHz and 120 kHz) used by the signal generator to inject the electrical signal. For example, after the calibration process, the signal generator may inject a 100 kHz and/or 80 kHz signal into the electrical loop for detecting electrical arcs.

In some examples, the calibration process can be performed initially during the setup or installation of the system. The calibration process performed initially can help establish the baseline frequencies at which arcs are most likely to release and/or absorb energy. Additionally and/or optionally, the system can calibrate periodically, in real-time during operation, and/or in response to specific triggers (e.g., a detection of change of environmental conditions). This can enable the system to account for changes in environmental conditions, such as temperature fluctuations, which can affect the frequencies at which arcs are most likely to release and/or absorb energy. In examples, calibration can be performed in conjunction with a purposely faulted component to characterize the response of the component due to the fault (e.g., what frequency or frequencies of energy are absorbed by the faulted component as opposed to a nominally functioning one). Analyses may also be performed to characterize similar characteristics of faulted components. Analyses and/or fault injection may be used to determine threshold(s) of energy diverted by an arc caused by a faulted component. The thresholds may correspond to different fault(s) and/or different component(s) such that the disclosed techniques may be used to identify a specific type of fault, identify a specific faulted component, or combinations of fault types/components.

In some examples, the system can support electrical arc detection one or more other electrical loops or circuits that are parallel to the electrical loop and connected to the power transmission component. For example, by controlling amplitude and/or frequency of injected signal generated by the signal generator, the system can be adaptable to detect an electrical arc under various circuit topologies (e.g., two or more electrical loops in parallel), complexities, and/or structures. In some examples, the first circuit and the second circuit can include one or more Fourier Transform (FT) circuits or Fast Fourier Transform (FFT) circuits. In some examples, the first circuit, the second circuit, and/or the processing circuit can be implemented or embodied as a digital signal processor (DSP) or other suitable types of processing circuitry.

Although the various aspects will be described in accordance with illustrative embodiments and combinations of features, one skilled in the relevant art will appreciate that the examples and combinations of features are illustrative in nature and should not necessarily be construed as limiting. More specifically, aspects of the present application may be applicable with various types of electrical systems and/or electromagnetic systems under different contexts (e.g., associated with a vehicle, a solar system, a battery system). Still further, although specific architectures of circuitry block diagrams for detecting electrical arcs will be described, such illustrative circuitry block diagrams or architecture should not necessarily be construed as limiting. Accordingly, one skilled in the relevant field of technology will appreciate that the aspects of the present application are not necessarily limited to being applied to any particular types of electrical arc detection systems.

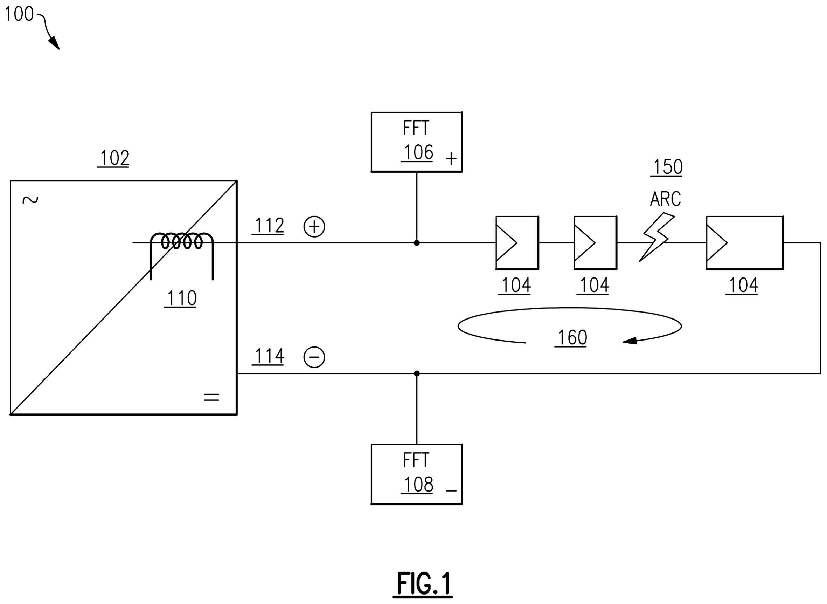

FIG. 1 is an example schematic block diagram of an electrical system 100 that can detect electrical arcs in accordance with some embodiments of the present disclosure. As shown in FIG. 1, the electrical system 100 can include at least a power transmission component 102, a first FFT circuit 106, a second FFT circuit 108, and electrical components 104. The power transmission component 102 includes a signal generator 110 as illustrated. The signal generator 110 can include a solenoid. The power transmission component 102 can have a first terminal 112 (e.g., a positive or non-inverting terminal) and a second terminal 114 (e.g., a negative or inverting terminal). The first FFT circuit 106 can be a 64 point FFT circuit, a 128 point FFT circuit, or the like, depending on desired frequency resolution for electrical arc detection. The first FFT circuit 106 can be electrically connected to the first terminal 112. The second FFT circuit 108 can be a 64 point FFT circuit, a 128 point FFT circuit, or the like, depending on desired frequency resolution for electrical arc detection. The second FFT circuit 108 can be electrically connected to the second terminal 114. The electrical components 104 can be electrically connected to the terminal 112 at one end, and electrically connected to the terminal 114 at the other end.

In some examples, the power transmission component 102 can be or include an inverter, a transformer, and/or other suitable power conversion and/or transmission circuitry that facilitate power transmission to and/or from the electrical components 104. For example, the power transmission component 102 can include a transformer that receives an alternating current (AC) signal and converts the AC signal into a DC signal for the electrical components 104. The power transmission component 102 can include the signal generator 110. Even when the signal generator 110 is implemented external to the power transmission component 102, the signal generator can be considered a part of the power transmission component 102.

In some examples, the signal generator 110 can inject, through the first terminal 112, an electrical signal at one or more particular frequencies (e.g., 100kHz, 20kHz and 80kHz) into the electrical loop 160 that includes the first terminal 112, the electrical components 104, and the second terminal 114. In the electrical loop 160, electrical components 104 are in series with each other. The signal generator 110 can superimpose the injected signal on a power signal that the power transmission component 102 provides to the electrical components 104. The injected signal can be a sinusoidal signal, for example. The one or more particular frequencies of the electrical signal can be determined (e.g., through a calibration process) based on the energy absorption characteristics of an electrical arc within the electrical components 104, thereby advantageously enabling the electrical system 100 to effectively detect electrical arcs by measuring and calculating changes in signal energy. By adjusting an amplitude and/or frequency of the electrical signal injected, the signal generator 110 can provide the electrical system 100 with the ability to improve the signal-to-noise ratio (SNR) associated with the detection of electrical arcs, thereby enhancing the accuracy and reliability for detecting electrical arcs.

In some examples, the electrical components 104 can include various types of components such as battery cells, solar cells, and/or the like. The electrical components 104 can be DC components. The electrical components 104 can be connected in series with each other between the first terminal 112 and the second terminal 114. In FIG. 1, the electrical components 104 are illustrated as being photovoltaic solar cells. During operation, an electrical arc 150 associated with a DC component of the electrical components 104 may occur. Using the signal generator 110, the first FFT circuit 106, and the second FFT circuit 108, the electrical system 100 may reliably detect the electrical arc 150.

More specifically, the first FFT circuit 106 can be electrically connected to the first terminal 112. The first FFT circuit 106 can measure (e.g., through frequency domain analysis to obtain energy distribution across a frequency band of interest such as between 10 kHz to 150 kHz) signal energy associated with the electrical signal at the one or more particular frequencies (e.g., 80 kHz) at the first terminal 112. More specifically, the first FFT circuit 106 can detect at the first terminal 112 signal energy of the injected signal (e.g., generated by the signal generator 110) superimposed on the power signal that the power transmission component 102 provides to the electrical components 104. The second FFT circuit 108 can be electrically connected to the second terminal 114. The second FFT circuit 108 can measure signal energy associated with the electrical signal at the one or more particular frequencies at the second terminal 114. More specifically, the second FFT circuit 108 can detect at the second terminal 114 signal energy of the injected signal (e.g., generated by the signal generator 110) superimposed on the power signal that the power transmission component 102 provides to the electrical components 104. Based at least in part on the signal energy measured at the second terminal 112 and the signal energy measured at the second terminal 114 (e.g., a difference between the signal energy at the terminal 112 and the terminal 114), a processing circuit (not shown in FIG. 1) of the electrical system 100 can determine an occurrence of the electrical arc 150 associated with the one or more electrical components 104. The difference in energy at the one or more particular frequencies can be due to absorption of the injected signal by the electrical arc 150.

Although FIG. 1 illustrates that the first FFT circuit 106 and the second FFT circuit 108 are respectively electrically connected to the first terminal 112 and the second terminal 114, the first FFT circuit 106 and the second FFT circuit 108 can be electrically connected to other suitable nodes in the electrical loop 160 in some other embodiments. The first FFT circuit 106 can be connected to a first node in the electrical loop 160 and the second FFT circuit 108 can be connected to a second node in the electrical loop 160, where the first node and the second node are on opposing sides of the electrical components 104 that are in series with each other. The first FFT circuit 106 can generate a measure of first signal energy associated with an electrical signal at one or more particular frequencies at a first end of the electrical components 104 in the electrical loop 160. The second FFT circuit 108 can generate a measure of first signal energy associated with an electrical signal at the one or more particular frequencies at a second end of the electrical components 104 in the electrical loop 160.

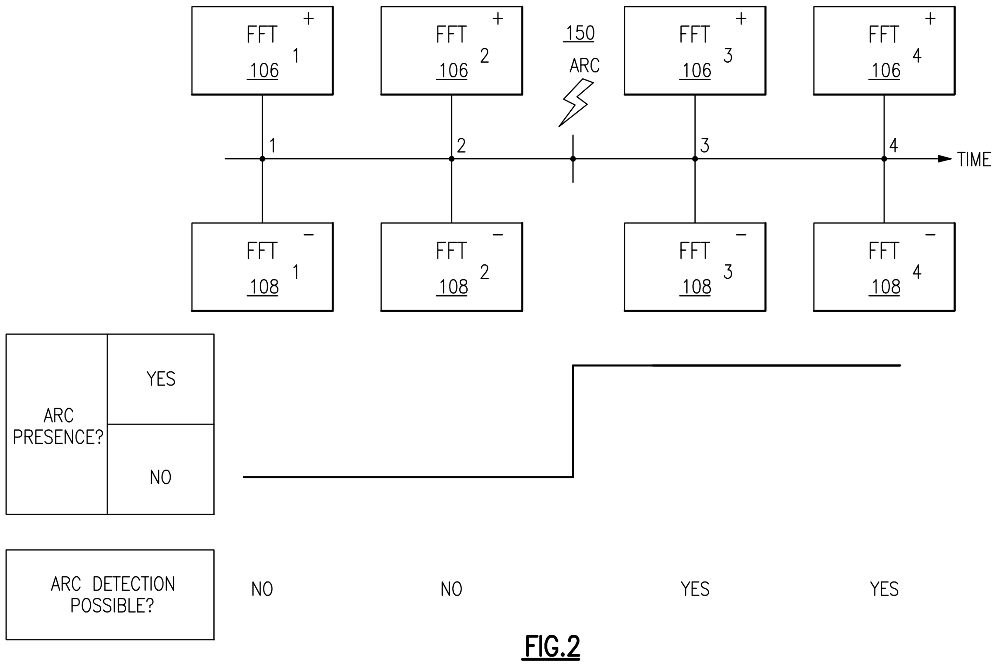

FIG. 2 illustrates an example timeline of detecting electrical arcs using the electrical system 100 (e.g., the first FFT circuit 106 and the second FFT circuit 108) of FIG. 1 in accordance with some embodiments of the present disclosure. As shown in FIG. 2, an electrical arc 150 can occur between timestamp 2 (e.g., 10 seconds after a reference time) and timestamp 3 (e.g., 10.5 seconds, 11 seconds, or 60 seconds after the reference time), and persist after the occurrence in the absence of corrective action. Figure 2 also shows that the arc continues in time after an occurrence.

In some examples, the first FFT circuit 106 and the second FFT circuit 108 can both measure signal energy at timestamp 3. For example, at the first terminal 112, the first FFT circuit 106 can measure signal energy at one or more particular frequencies (e.g., one or more frequencies at which the electrical arc 150 absorbs significant and/or the most energy such as 20kHz, 90 kHz, and 120 kHz). At the second terminal 114, the second FFT circuit 108 measures signal energy at the one or more particular frequencies. Because of the occurrence of the electrical arc 150 associated with one or more electrical components 104 of the electrical components 104, the signal energy measured by the first FFT circuit 106 may be higher than (e.g., greater than 3 dB, 5 dB, 10 dB, or other levels) the signal energy measured by the second FFT circuit 108. By comparing a difference between the signal energy measured by the first FFT circuit 106 and the signal energy measured by the second FFT circuit 108 at timestamp 3, a processing circuit (not shown in FIG. 2) can determine an occurrence of the electrical arc 150.

In some examples, the processing circuit can determine an occurrence of the electrical arc 150 based on both signal energy calculated before and after the occurrence of the electrical arc 150. For example, besides using signal energy measured at timestamp 3, the processing circuit can also utilize signal energy measured by the first FFT circuit 106 and the second FFT circuit 108 at timestamp 2 for determining the occurrence of the electrical arc 150. For example, the signal energy at the one or more particular frequencies measured by the first FFT circuit 106 and the second FFT circuit 108 at timestamp 2 can be similar to each other because the electrical arc 150 has not yet occurred at timestamp 2. Based on the signal energy measured both at timestamp 2 and timestamp 3 (e.g., signal energy measured being similar at timestamp 2, but being quite different at timestamp 3), the electrical system 100 can determine that the electrical arc 150 occurs between timestamp 2 and timestamp 3.

Advantageously, by injecting (e.g., using the signal generator 110) an electrical signal at one or more particular frequencies for detecting electrical arcs as illustrated in FIG. 1 and FIG. 2, the SNR associated with electrical arc detection can be enhanced or improved compared with existing methods that rely on uncontrolled signals to detect electrical arcs. The improved SNR can reduce the likelihood of false positives and/or nuisance tripping, leading to more reliable and accurate electrical arc detection. Additionally, by measuring signal energy at multiple nodes (e.g., the first terminal 112 and the second terminal 114) in the electrical loop 160 and comparing signal energy at the multiple nodes before and/or after an occurrence of the electrical arc 150, the electrical arc 150 can be detected at any time after an occurrence of the electrical arc 150. In contrast, certain existing methods that measure signal energy at a single node of an electrical circuit may only detect an electrical arc within a relatively narrow time window (e.g., shortly after an occurrence of the electrical arc 150). This can be because these existing methods involve comparing energy levels measured at different timestamps or points of time (e.g., before and after an occurrence of the electrical arc 150), and determining the occurrence of the electrical arc 150 if a difference between energy levels measured at two timestamps exceeds a threshold. As such, existing methods may not detect the electrical arc 150 by comparing energy levels measured both after the occurrence of the electrical arc 150 or by comparing energy levels measured both before the occurrence of the electrical arc 150.

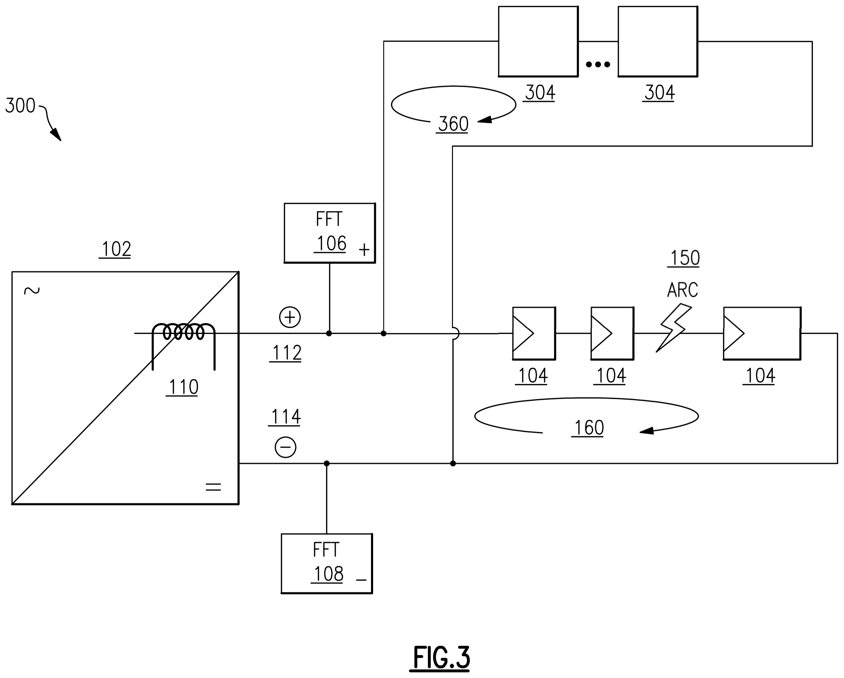

FIG. 3 is an example schematic block diagram of an electrical system 300 that can detect electrical arcs in accordance with some embodiments of the present disclosure. As shown in FIG. 3, the electrical system 300 includes at least a power transmission component 102 with a signal generator 110, a first FFT circuit 106, a second FFT circuit 108, electrical components 104, and electrical components 304. In contrast to the electrical system 100 of FIG. 1 that includes the electrical loop 160, the electrical system 300 can further include a second electrical loop 360 that includes electrical components 304 in series with each other. The electrical components 304 can include any suitable features of the electrical components 104. The second electrical loop 360 can be in parallel with the electrical loop 160 as illustrated in FIG. 3.

In some examples, the signal generator 110 can inject one or more electrical signals into both the electrical loop 160 and the second electrical loop 360 to detect the electrical arc 150 associated with one or more of the electrical components 104 as well as an electrical arc (not shown in FIG. 3) associated with one or more of the electrical components 304. In some examples, the electrical system 300 can employ additional FFT circuits (not shown in FIG. 3) and/or measure signal energy at additional nodes (e.g., besides the first terminal 112 and the second terminal 114) in the second electrical loop 360 and the electrical loop 160, which may enhance performance of detection (e.g., through improved SNR associated with detection). Advantageously, by using the first FFT circuit 106 and the second FFT circuit 108 to measure energy levels and comparing a difference between energy levels measured by the first FFT circuit 106 and the second FFT circuit 108, the electrical system 300 can reliably detect the electrical arc 150. For example, the electrical system 300 can reliably determine an occurrence of the electrical arc 150 when the difference exceeds a threshold, under the presence of system variations and/or variations in environmental conditions.

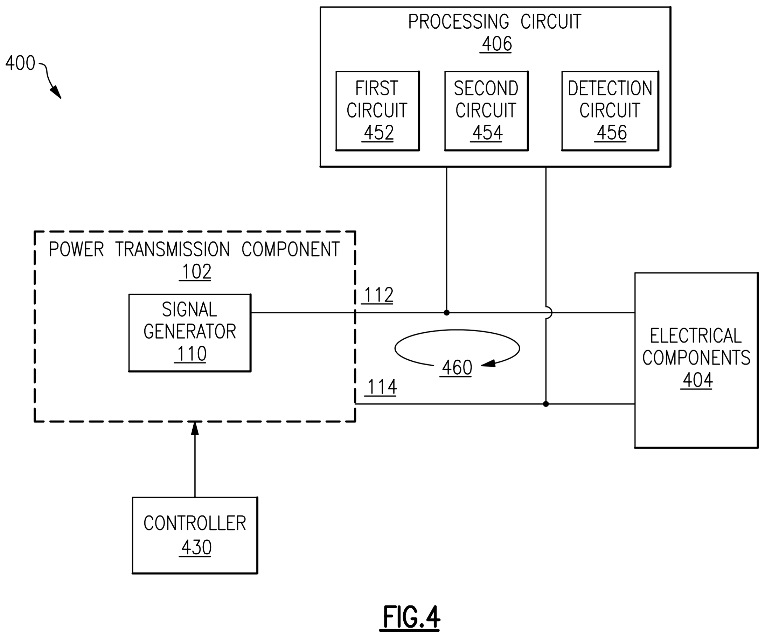

FIG. 4 is an example schematic block diagram of an electrical system 400 that can detect electrical arcs in accordance with some embodiments of the present disclosure. As shown in FIG. 4, the electrical system 400 can include a power transmission component 102 with a signal generator 110, a processing circuit 406, one or more electrical components 404, and a controller 430. The power transmission component 102 includes a first terminal 112 and a second terminal 114. The processing circuit 406 and the controller 430 can be considered separate elements of the electrical system 400 from the power transmission component 102 due to their separate functionality, even if the processing circuit 406 and/or the controller 430 are physically implemented in a power transmission component 102 (e.g., an inverter). The processing circuit 406 can be implemented by dedicated circuitry (e.g., application specific integrated circuit (ASIC)) and/or general purpose circuitry (e.g., digital signal processor (DSP)). Unless otherwise noted, the components of FIG. 4 can be structurally and/or functionally the same as or generally similar to like-numbered components of FIG. 1 and FIG. 3.

In some examples, the processing circuit 406 may be embodied as a microprocessor, central processing unit (CPU), digital signal processor (DSP), microcontroller, or other processor or processing/controlling circuit. The processing circuit 406 may implement and/or perform the functionality of the FFT circuit 106 and/or the FFT circuit 108 of any of FIG. 1, 2, and 3 to measure signal energy at one or more particular frequencies at the first terminal 112 and the second terminal 114. Based on the measured signal energy (e.g., a difference between measured signal energy at the first terminal 112 and the second terminal 114), the processing circuit 406 can further determine an occurrence of an electrical arc.

In some examples, for example as shown in FIG. 4, the processing circuit 406 may include a first circuit 452, a second circuit 454, and a detection circuit 456. The first circuit 452 can implement and/or perform the functionality of the first FFT circuit 106. For example, the first circuit 452 can include dedicated circuitry for performing FFTs. The second circuit 454 can implement and/or perform the functionality of the second FFT circuit 108. For example, the second circuit 454 can include dedicated circuitry for performing FFTs. Based on signal energy measured by the first circuit 452 and the second circuit 454, the detection circuit 456 can determine an occurrence of an electrical arc associated with the electrical components 404. In some examples, the first circuit 452 and/or the second circuit 454 can include processing circuitry such as DSP, ASIC, or other suitable processing/controlling circuitry (rather than dedicated FFT circuitry). The first circuit 452 and/or the second circuit 454 can be reconfigurable for detecting signal energy at various frequencies based on applications. In some examples, the first circuit 452 and/or the second circuit 454 can include Fourier Transform (FT) circuits.

In some examples, the electrical components 404 can include electrical components (e.g., battery cells, solar cells), and/or other electrical elements. The signal generator 110 can inject one or more electrical signals through the first terminal 112 toward the electrical components 404 to detect an occurrence of an electrical arc associated with one or more of the electrical components 404. The controller 430 can provide control signal(s) to adjust the operation of the signal generator 110, thereby achieving accurate electrical arc detection. For example, based on number of elements in the electrical components 404, the controller 430 can cause the signal generator 110 to adjust amplitude and/or frequency of the one or more electrical signals injected through the first terminal 112.

In some examples, the controller 430 can control the signal generator 110 to inject an electrical signal having one or more particular frequencies into an electrical loop 460 that includes the electrical components 404 coupled between the first terminal 112 and the second terminal 114. The one or more particular frequencies can be determined based on energy absorption characteristics of electrical arcs associated with one or more of the electrical components 404. For example, the controller 430 can perform a calibration process (e.g., through frequency sweeping) to characterize or determine frequencies at which electrical arcs associated with the one or more electrical components 404 occur and/or absorb the most energy. More specifically, the controller 430 can control the signal generator 110 to inject calibration signals at various frequencies (e.g., from 10 kHz to 150 kHz) toward the electrical components 404. The processing circuit 406 can analyze responses associated with the calibration signals to determine a frequency at which electrical arcs associated with the one or more electrical components 404 absorb the most energy. The controller 430 may then set the one or more frequencies (e.g., 100 kHz) at which electrical arcs absorb the most energy as the one or more particular frequencies (e.g., 100 kHz) used by the signal generator 110 to inject the electrical signal for detecting electrical arcs. For example, after the calibration process, the signal generator may inject a 100 kHz signal (e.g., the electrical signal) into the electrical loop 460 for detecting electrical arcs. In some instances, the functionality of the controller 430 and the processing circuit 406 can be implemented by a common integrated circuit, such as a DSP. For example, at least portions of the functionality of the controller 430 and the processing circuit 406 can be implemented by a single DSP.

In some examples, the controller 430 may optionally control the signal generator 110 to inject signals for detecting electrical arcs during some periods of time that will result in less interference on operations of the electrical system 400. For example, the controller 430 may control the signal generator 110 to inject signals for detecting electrical arcs when the power transmission component 102 is not delivering or pauses delivering power to the electrical components 404.

In some examples, responsive to the detection circuit 456 determining an occurrence of the electrical loop 460, the controller 430 may take or facilitate one or more responsive actions. For example, the controller 430 may generate an alert or warning signal to indicate the occurrence of the electrical loop 460. As another example, the controller 430 may stop power transmission from the power transmission component 102 to the electrical components 404. As yet another example, the controller 430 may restart (e.g., following a restart protocol) the electrical system 400 or activate some safety protocols to mitigate risks associated with the occurrence of the electrical loop 460.

The foregoing disclosure is not intended to limit the present disclosure to the precise forms or particular fields of use disclosed. As such, it is contemplated that various alternate embodiments and/or modifications to the present disclosure, whether explicitly described or implied herein, are possible in light of the disclosure. Having thus described embodiments of the present disclosure, a person of ordinary skill in the art will recognize that changes may be made in form and detail without departing from the scope of the present disclosure. Thus, the present disclosure is limited only by the claims.

It is to be understood that not necessarily all objects or advantages may be achieved in accordance with any particular example described herein. Thus, for example, those skilled in the art will recognize that some examples may be operated in a manner that achieves or optimizes one advantage or group of advantages as taught herein without necessarily achieving other objects or advantages as may be taught or suggested herein.

All of the processes described herein may be embodied in, and fully automated via, software code modules executed by a computing system that includes computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the example, some acts, events, or functions of any of the algorithms described herein can be performed in a different sequence, can be added, merged, or left out altogether (for example, not all described acts or events are necessary for the practice of the algorithms). Moreover, in some examples, acts or events can be performed concurrently, for example, through multi-threaded processing, interrupt processing, or multiple processors or processor cores, or on other parallel architectures, rather than sequentially. In addition, different tasks or processes can be performed by different machines and/or computing systems that can function together.

The various illustrative logical blocks and modules described in connection with the examples disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combination of the same, or the like. A processor can include electrical circuitry to process computer-executable instructions. In some examples, a processor includes an FPGA or other programmable device that performs logic operations without processing computer-executable instructions. A processor can also be implemented as a combination of computing devices, for example, a combination of a DSP and a microprocessor, a plurality of microprocessors, microprocessors in conjunction with a DSP core, or any other such configuration. Although described herein primarily with respect to digital technology, a processor may also include primarily analog components. A computing environment can include any type of computer system, including, but not limited to, a computer system based on a microprocessor, a mainframe computer, a digital signal processor, a portable computing device, a device controller, or a computational engine within an appliance, to name a few.

The elements of a method, process, routine, or algorithm described in connection with the embodiments disclosed herein can be embodied directly in hardware, in a software module executed by a processor device, or in a combination of the two. A software module can reside in RAM memory, flash memory, ROM memory, EPROM memory, EEPROM memory, registers, hard disk, a removable disk, a CD-ROM, or any other form of a non-transitory computer-readable storage medium. An exemplary storage medium can be coupled to the processor device such that the processor device can read information from, and write information to, the storage medium. In the alternative, the storage medium can be integral to the processor device. The processor device and the storage medium can reside in an ASIC. The ASIC can reside in a user terminal. In the alternative, the processor device and the storage medium can reside as discrete components in a user terminal.

The processes described herein or illustrated in the figures of the present disclosure may begin in response to an event, such as on a predetermined or dynamically determined schedule, on demand when initiated by a user or system administrator, or in response to some other event. When such processes are initiated, a set of executable program instructions stored on one or more non-transitory computer-readable media (e.g., hard drive, flash memory, removable media, etc.) may be loaded into memory (e.g., RAM) of a server or other computing device. The executable instructions may then be executed by a hardware-based computer processor of the computing device. In some embodiments, such processes or portions thereof may be implemented on multiple computing devices and/or multiple processors, serially or in parallel.

Conditional language such as, among others, "can," "could," "might" or "may," unless specifically stated otherwise, are otherwise understood within the context as used in general to convey that some examples include, while other examples do not include, some features, elements and/or steps. Thus, such conditional language is not generally intended to imply that features, elements and/or steps are in any way for examples or that examples necessarily include logic for deciding, with or without user input or prompting, whether these features, elements and/or steps are included or are to be performed in any particular example.

Disjunctive language such as the phrase "at least one of X, Y, or Z," unless specifically stated otherwise, is otherwise understood with the context as used in general to present that an item, term, etc., may be either X, Y, or Z, or any combination thereof (for example, X, Y, and/or Z). Thus, such disjunctive language is not generally intended to, and should not, imply that some examples require at least one of X, at least one of Y, or at least one of Z to each be present.

Any process descriptions, elements or blocks in the flow diagrams described herein and/or depicted in the attached figures should be understood as potentially representing modules, segments, or portions of code which include executable instructions for implementing specific logical functions or elements in the process. Alternate examples are included within the scope of the examples described herein in which elements or functions may be deleted, executed out of order from that shown, or discussed, including substantially concurrently or in reverse order, depending on the functionality involved as would be understood by those skilled in the art.

It should be emphasized that many variations and modifications may be made to the above-described examples, the elements of which are to be understood as being among other acceptable examples. All such modifications and variations are intended to be included herein within the scope of this disclosure.

Any process descriptions, elements or blocks in the flow diagrams described herein and/or depicted in the attached figures should be understood as potentially representing modules, segments, or portions of code which include executable instructions for implementing specific logical functions or elements in the process. Alternate implementations are included within the scope of the examples described herein in which elements or functions may be deleted, executed out of order from that shown, or discussed, including substantially concurrently or in reverse order, depending on the functionality involved as would be understood by those skilled in the art.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B, and C" can include a first processor configured to carry out recitation A working in conjunction with a second processor configured to carry out recitations B and C.

## Claims

1. An electrical system with electrical arc detection, the electrical system comprising:
a power transmission component having a first terminal and a second terminal, the power transmission component comprising a signal generator configured to inject an electrical signal to one or more electrical components that are coupled between the first terminal and the second terminal;
the one or more electrical components;
a first circuit electrically connected to the first terminal, the first circuit configured to measure first signal energy associated with the electrical signal at one or more particular frequencies at the first terminal;
a second circuit electrically connected to the second terminal, the second circuit configured to measure second signal energy associated with the electrical signal at the one or more particular frequencies at the second terminal; and
a detection circuit in communication with the first circuit and the second circuit,
the detection circuit configured to detect an occurrence of an electrical arc associated with the one or more electrical components based at least in part on the first signal energy and the second signal energy.

2. The electrical system of Claim 1, wherein the detection circuit determines the occurrence of the electrical arc associated with the one or more electrical components based at least in part on a difference between the first signal energy and the second signal energy.

3. The electrical system of Claim 1 or 2, wherein the first circuit measures the first signal energy after the occurrence of the electrical arc and the second circuit measures the second signal energy after the occurrence of the electrical arc.

4. The electrical system of one of the preceding claims, wherein the detection circuit determines the occurrence of the electrical arc associated with the one or more electrical components based on the first signal energy, the second signal energy, third signal energy, and fourth signal energy, and wherein:
the first circuit is configured to measure the third signal energy associated with the electrical signal at the one or more particular frequencies at the first terminal prior to the occurrence of the electrical arc; and
the second circuit is configured to measure the fourth signal energy associated with the electrical signal at the one or more particular frequencies at the second terminal prior to the occurrence of the electrical arc.

5. The electrical system of one of the preceding claims, wherein the one or more particular frequencies are in a range from 10 kilohertz (kHz) to 150 kHz, and/or wherein the first circuit comprises a Fourier Transform (FT) circuit.

6. The electrical system of one of the preceding claims, wherein the one or more electrical components comprise at least one of: a solar cell or a battery cell, and/or wherein the one or more electrical components comprise a plurality of electrical components in series with each other between the first terminal and the second terminal.

7. The electrical system of one of the preceding claims, wherein the signal generator comprises a solenoid.

8. The electrical system of one of the preceding claims, further comprising additional electrical components coupled between the first terminal and the second terminal, the additional electrical components in series with each other and in parallel with the one or more electrical components, wherein the signal generator is configured to inject a second electrical signal to the additional electrical components, and wherein the detection circuit is configure to detect an occurrence of a second electrical arc associated with the additional electrical components based at least in part on the first signal energy and the second signal energy.

9. A method of detecting an electrical arc associated with one or more electrical components, the method comprising:
injecting an electrical signal into an electrical loop, the electrical loop comprising a first terminal of a power transmission component, a second terminal of the power transmission component, and the one or more electrical components electrically coupled between the first terminal and the second terminal;
generating a first indication of first signal energy associated with the electrical signal at one or more particular frequencies at the first terminal;
generating a second indication of second signal energy associated with the electrical signal at the one or more particular frequencies at the second terminal; and
detecting the electrical arc associated with the one or more electrical components based at least in part on the first indication and the second indication.

10. The method of Claim 9, further comprising:
injecting one or more calibration signals into the electrical loop;
receiving one or more electrical responses associated with the one or more calibration signals from the electrical loop; and
determining, based on the one or more electrical responses, that electrical arcs associated with the one or more electrical components cause significant energy absorption in the electrical loop at the one or more particular frequencies.

11. The method of Claim 9 or 10, wherein the first indication and the second indication are generated after an occurrence of the electrical arc.

12. The method of one of Claims 9 to 11, further comprising:
generating a third indication of third signal energy associated with the electrical signal at the one or more particular frequencies at the first terminal prior to the occurrence of the electrical arc;
generating a fourth indication of fourth signal energy associated with the electrical signal at the one or more particular frequencies at the second terminal prior to the occurrence of the electrical arc; and
detecting the electrical arc associated with the one or more electrical components based on the first indication, the second indication, the third indication, and the fourth indication.

13. The method of one of Claims 9 to 12, wherein the one or more particular frequencies are in a range from 10 kilohertz (kHz) to 150 kHz, and/or wherein generating the first indication uses a first Fourier Transform (FT) circuit and generating the second indication uses a second Fourier Transform (FT) circuit.

14. The method of one of Claims 9 to 13, wherein the one or more electrical components comprise at least one of: a solar cell, or a battery cell, and/or wherein the one or more electrical components comprise a plurality of electrical components in series with each other between the first terminal and the second terminal.

15. The method of one of Claims 9 to 14, wherein the power transmission component comprises an inverter or a transformer, and/or wherein the electrical signal is injected into the electrical loop by a solenoid.
